# EUROPEAN PATENT APPLICATION

(11) **EP 2 696 372 A1**
(43) Date of publication of application: **12.02.2014**
(21) Application number: 11862897.3
(22) Date of filing: 30.11.2011
(51) Int. Cl.: H01L 31/042

(54) **METAL OXIDE SEMICONDUCTOR ELECTRODE HAVING POROUS THIN FILM, DYE-SENSITIZED SOLAR CELL USING SAME, AND METHOD FOR MANUFACTURING SAME**

(30) Priority: 04.04.2011 KR 20110030835
(71) Applicant: Postech Academy-Industry Foundation, Pohang-si, Gyeongsangbuk-do 790-784 (KR)
(72) Inventor: PARK, Taiho, Pohang-si 790-751 (KR); KWON, Young-Soo, Pohang-si 790-784 (KR); PARK, Sung Hae, Busan 607-060 (KR); LIM, Jong Chul, Anseong-si 456-747 (KR); SONG, In Young, Incheon 402-806 (KR)
(74) Representative: Ahner, Philippe
(86) International application number: PCT/KR2011/009217
(87) International publication number: WO 2012/138036

(57) **Abstract**

The present invention relates to a dye-sensitized solar cell and to a method for manufacturing same, and more specifically, to a novel dye-sensitized solar cell for preventing photoelectron recombination due to a triiodide, and to a method for manufacturing same. The dye-sensitized solar cell, according to the present invention, comprises a metal oxide which is produced by co-adsorption of a reactive compound, which can react with iodine, with a dye on a surface of the dye-sensitized solar cell. The dye-sensitized solar cell can achieve high efficiency by preventing the photoelectron recombination due to the triiodide while using a small amount of the dye.

## Description

### Technical Field

The present invention relates to a dye-sensitized solar cell and a method of manufacturing the same, and, more particularly, to a novel dye-sensitized solar cell, which may prevent photoelectron recombination due to a triiodide and desorption of a dye, and to a method of manufacturing the same.

### Background Art

Solar cells are devices which directly produce electricity using a light-absorbing material which generates electrons and holes upon irradiation of light, and are based on a photovoltaic effect. The photovoltaic effect in which a chemical reaction induced by light generates current was first discovered by Becquerel, a French physicist, in 1839, and a phenomenon similar thereto was then found in a solid such as selenium.

In 1991, the Switzerland Grätzel research team published a method of manufacturing a solar cell having a photoelectric conversion efficiency of 10% by chemically adsorbing a Ru(porphyrin) dye on anatase TiO₂ having a nano crystal structure and by using iodine and an iodine salt dissolved in a solution electrolyte. The photoelectric conversion efficiency of the dye-sensitized solar cell (hereinafter referred to as "DSSC") is known to be higher than that of typical amorphous silicon-based solar cells, and the DSSC is currently regarded as the most advanced technology able to substitute for silicon diodes.

The DSSC includes a semiconductor electrode made of porous titanium dioxide (TiO₂) nanoparticles adsorbed with dye molecules, a counter electrode coated with platinum or carbon, and an electrolyte charged between the semiconductor electrode and the counter electrode. Briefly, the DSSC is a solar cell comprising a transparent electrode and a metal electrode, inorganic oxide layer such as titanium oxide which is adsorbed with a dye, and an electrolyte filling between the electrodes, and using a photoelectrochemical reaction.

Typically, the DSSC includes two electrodes (a photoelectrode and a counter electrode), an inorganic oxide, a dye and an electrolyte. The DSSC is eco-friendly because it uses an environmentally harmless material, and it has high energy conversion efficiency corresponding to that of amorphous silicon-based solar cells among conventional inorganic solar cells, and the manufacturing cost thereof is merely about 20% of that of silicon solar cells, and thus DSSC has been reported to have very high commercialization potential (US Patent Nos. 4,927,721 and 5,350,644).

In the operating principle of the DSSC, when light is radiated onto a dye-adsorbed titanium oxide layer, the dye absorbs photons (electron-hole pairs) to form excitons, and the formed excitons are converted from a ground state into an excited state. Thereby, the electron-hole pairs are separated, so that the electrons are implanted into the titanium oxide layer, and the holes are transported into the electrolyte layer. Further, when an external circuit is provided, the electrons are transported to a cathode from an anode via the titanium oxide layer through conductive wires, thus generating current. The electrons transported to the cathode are reduced by the electrolyte, and the electrons in an excited state are continuously transported, thus generating current.

In order to increase the photoelectric conversion efficiency of the DSSC, the absorption of solar light should be increased first so that the production of electrons increases. Because the absorption of solar light is proportional to the amount of adsorbed dye, the adsorption of the dye should be increased in order to raise the absorption of solar light, and oxide semiconductor particles are manufactured on a nanometer scale in order to increase the adsorption of the dye per unit area, thereby enlarging the surface area of the oxide semiconductor. However, limitations are imposed on increasing the photoelectric conversion efficiency of solar cells using such methods.

The electrons transported to the semiconductor oxide by the dye may be recombined with oxidized chemical species present in solar cells while passing through the semiconductor oxide layer, undesirably losing photoelectrons. Particularly, in the DSSC using iodine and iodine ions as oxidation-reduction species, recombination is known to be mainly caused by a reaction between photoelectrons present on the surface of metal oxide and triiodide ions or oxidized dye.

Thus, methods of preventing the photoelectrons from approaching the oxidation species or preventing the oxidation species from approaching the photoelectrons have been developed. First, there is provided a method of introducing ethyleneglycol to the hole transport material of a p-type semiconductor to chelate lithium ions, thus screening electrons which approach from TiO₂ to thereby delay the recombination (Taiho Park, et al., Chem. Comm. 2003, 11, 2878; Saif A. Haque, et al., Adv. Func. Mater. 2004, 14, 435). Second, there is provided a method of adding a base having high toxicity, for example, a tertiary aromatic amine to an electrolyte to improve open-circuit voltage (M. K. Nazeeruddin, et al., J. Am. Chem. Soc., 1993, 115, 6382).

Also, there have been exemplified the formation of an insulating layer on the exposed surface of the semiconductor oxide layer of a semiconductor electrode and the exposed surface of a conductive substrate (Korean Unexamined Patent Publication No. 2008-0029597) and the adsorption of a dye on the surface of a semiconductor electrode coated with aluminum oxide or another metal oxide (Emilio Palomares, et al., J. Am. Chem. Soc. 2003, 125, 475-482; Shlomit Chappel, et al., Langmuir 2002, 18, 3336-3342).

In addition, a method of preventing leakage of an electrolyte by mixing a polymer thin film with the electrolyte has been disclosed (Korean Unexamined Patent Publication No. 2009-0012911).

However, in the aforementioned methods, it is difficult to control the recombination of photoelectrons occurring on the surface of the metal oxide, and thus there is a continuous need for methods that are able to solve such problems.

Further, the dye is adsorbed by forming a carboxylate on the surface of TiO₂, and the chemically bound dye is desorbed by water molecules present in the electrolyte or nucleophilic molecules produced via thermal decomposition of the electrolyte at high temperature, and is thus dissolved in the electrolyte, and the dissolved dye cannot produce photoelectrons, undesirably lowering the efficiency of the DSSC, which is known to be mainly caused by the desorption of the dye. In order to ensure long-term stability of the DSSC, methods of preventing desorption of the dye from the inside of the DSSC or of re-adsorbing the dye even when the dye is desorbed are required.

### Disclosure

### Technical Problem

An object of the present invention is to provide a novel method which prevents a triiodide ion from approaching the surface of a metal oxide, thereby increasing optical efficiency of a dye-sensitized solar cell and ensuring long-term stability.

Another object of the present invention is to provide a novel method which prevents a triiodide ion from approaching the surface of a metal oxide and may prevent desorption of a dye.

Still another object of the present invention is to provide a method which prevents a triiodide ion from approaching the surface of a metal oxide and may disperse a dye while preventing desorption of the dye to thereby increase optical efficiency.

Yet another object of the present invention is to provide a method of fixing a porous thin film, which prevents a triiodide ion from approaching the surface of a metal oxide and may prevent desorption of a dye, to the surface of the metal oxide.

### Technical Solution

According to the present invention, a dye-sensitized solar cell is configured such that a porous thin film is formed on the surface of a metal oxide.

In an aspect of the present invention, a dye-sensitized solar cell comprises a semiconductor electrode, a counter electrode and an electrolyte, wherein the semiconductor electrode is configured such that a polymer thin film is formed on a porous thin layer including a metal oxide semiconductor and adsorbed with a dye.

In an aspect of the present invention, a metal oxide semiconductor electrode is configured such that a polymer thin film is formed on a porous thin layer including metal oxide semiconductor particles and adsorbed with a dye.

In an aspect of the present invention, a method of manufacturing a dye-sensitized solar cell comprises forming a porous thin film on a porous thin layer including metal oxide semiconductor particles.

In an aspect of the present invention, a dye-sensitized solar cell including iodine/iodide as a redox couple is configured such that a porous thin film having pores smaller than triiodide ions is formed on the surface of a semiconductor electrode.

In the present invention, the porous thin film is not theoretically limited, but has low permeability with respect to the oxidation species of the redox couple contained in the electrolyte, for example, cations to be recombined with electrons, that is, triiodide ions. For example, the porous thin film has a pore size smaller than the triiodide ions, thus preventing the oxidation species from approaching the oxide semiconductor, thereby decreasing the extent of lowering efficiency due to electron recombination.

In the present invention, the porous thin film is preferably a polymer porous thin film, and the polymer porous thin film may be fixed to the metal oxide so that desorption of the adsorbed dye is prevented.

In the present invention, the porous polymer thin film is preferably fixed to the metal oxide by means of a material which is co-adsorbed on the metal oxide along with a dye. More preferably, dye molecules are adsorbed along with a reactive co-adsorbent, and then a monomer and a cross-linking agent are applied and copolymerized on the surface of the metal oxide electrode adsorbed with the dye and the material, thus forming a porous polymer thin film fixed to the metal oxide by means of the material.

In the present invention, upon manufacturing the porous polymer thin film from the mixture of the monomer and the cross-linking agent, an olefinic monomer having a double bond may be used alone or in a mixture of two or more, and as the cross-linking agent, a compound wherein two or more compounds used as the monomer are connected may be used alone or in a mixture of two or more.

In an embodiment of the present invention, the porous polymer is preferably a cross-linked acrylic polymer, and may be, for example, a cross-linked polymer obtained by cross-linking methylmethacrylate, ethylmethacrylate, ethylhexylacrylate, or methylacrylate using a cross-linking agent.

Upon manufacturing the porous polymer thin film from the mixture of the monomer and the cross-linking agent, a mixture of epoxy and amine compounds able to perform a cross-linking reaction based on a ring-opening reaction of epoxy and amine may be used.

In the present invention, upon manufacturing the porous polymer thin film from the mixture of the monomer and the cross-linking agent, when an olefinic monomer having a double bond, which may be used alone or in a mixture of two or more, and the cross-linking agent in which a compound wherein two or more compounds used as the monomer are connected may be used alone or in a mixture of two or more, are copolymerized, an azo-based compound, a peroxide-based reaction initiator, light or heat may be selectively mixed depending on the properties of the monomer and the cross-linking agent. Further, upon manufacturing the porous polymer thin film from the mixture of the monomer and the cross-linking agent, when a mixture of epoxy and amine compounds able to perform a cross-linking reaction based on a ring-opening reaction of epoxy and amine is applied, an acidic or basic catalyst may be used.

In the present invention, as the reactive co-adsorbent, compounds represented by the following general formulas (1) to (6) including, at a terminal thereof, a cross-linkable double bond, epoxy, or amine, and, at one side thereof, a carboxyl group, acyl halide, alkoxy silyl, halide silyl or phosphorus which enables the adsorption on a semiconductor metal oxide electrode may be used alone or in mixtures of two or more.

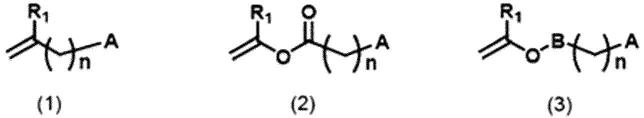

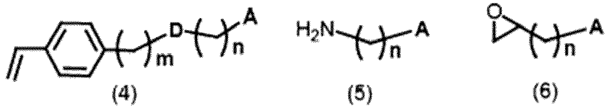

In the above formulas, R₁ is hydrogen, or a C1 ∼ C10 alkyl group, and A is a reactive group able to be adsorbed on the surface of a metal oxide while containing a carboxyl group, acyl halide, alkoxy silyl, halide silyl or phosphorus. B is a carbon atom, a nitrogen atom, an oxygen atom, a silicon atom, a phosphorus atom, etc. n is a natural number of 1 ∼ 40. m is 0 or a natural number of 1 ∼ 10. D is a connector including a carbon atom, a nitrogen atom, an oxygen atom, a silicon atom, a phosphorus atom or mixtures thereof. Examples of general formula (1) include but-3-enoic acid, pent-4-enoic acid, hex-4-enoic acid, hep-4-enoic acid, non-9-enoic acid, etc. Examples of general formula (2) include malonic acid monovinylester, succinic acid monovinylester, heptanedioic acid monovinylester, etc. Examples of general formula (3) include 4-oxo-hex-5-enoic acid, acrylic acid carboxymethyl ester, methacryloyl-4-aminobutyric acid, 6-acryloylamino-hexanoic acid, 9-acryloylamino-nonanoic acid, 6-(2-methyl-acryloylamino)-hexanoic acid, 9-(2-methyl-acryloylamino)-nonanoic acid, 14-acryloyloxy-tetradecanoic acid, 14-(2-methyl-acryloyloxy-tetradecanoic acid), etc. Examples of general formula (4) include 4-(4-vinyl-phenyl)butyric acid, 4-(4-vinyl-phenoxy)-propionic acid, 6-(4-vinyl-phenyl)hexylic acid, 6-(4-vinyl-phenoxy)-hexanoic acid, etc. Examples of general formula (5) include 6-amino-hexanoic acid, 8-amino-octanoic acid, etc. Examples of general formula (6) include 6-oxyrenyl-hexanoic acid, 8-oxyrenyl-octanoic acid, etc.

In the case where the reactive co-adsorbent is an olefin having a double bond in the present invention, monomers represented by the following general formulas (7) to (10) may be used alone or in mixtures of two or more to form a cross-linkage. Also, in the case where the reactive co-adsorbent is epoxy, an amine represented by the following general formula (11) may be used, and in the case where the reactive co-adsorbent is an amine, an epoxy represented by the following general formula (12) may be used.

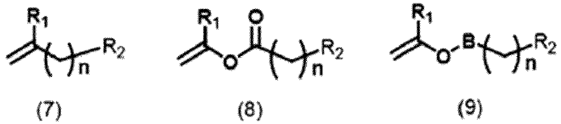

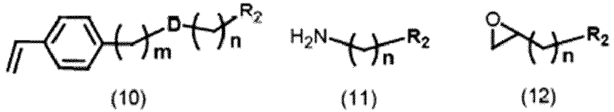

In the above formulas, R₁ is hydrogen, or a C1 ∼ C10 alkyl group, and R₂ is a terminal group containing hydrogen, nitrogen, silicon, phosphorus or carbon. B is a carbon atom, a nitrogen atom, an oxygen atom, a silicon atom, a phosphorus atom, etc. n is 0 or a natural number of 1 ∼ 20. m is 0 or a natural number of 1 ∼ 10. D is a connector including a carbon atom, a nitrogen atom, an oxygen atom, a silicon atom, a phosphorus atom or mixtures thereof.

As the cross-linking agent, a compound comprising one or more connected by R₂ among the compounds represented by general formulas (7) to (12) may be used alone or in a mixture of two or more.

In the present invention, the dye-sensitized solar cell comprises a semiconductor electrode comprising conductive first electrode, a metal oxide semiconductor layer formed on the first electrode, and one or more dye molecules adsorbed on the metal oxide semiconductor layer, and a counter electrode having a metal layer formed on a second substrate.

The present invention provides a method of manufacturing the dye-sensitized solar cell, which comprises inserting an electrolyte including an oxidation-reduction derivative between the semiconductor electrode and the counter electrode, or applying a polymer gel electrolyte composition including an oxidation-reduction derivative on the semiconductor electrode, thus forming a polymer gel electrolyte, on which a second electrode is then positioned and bound.

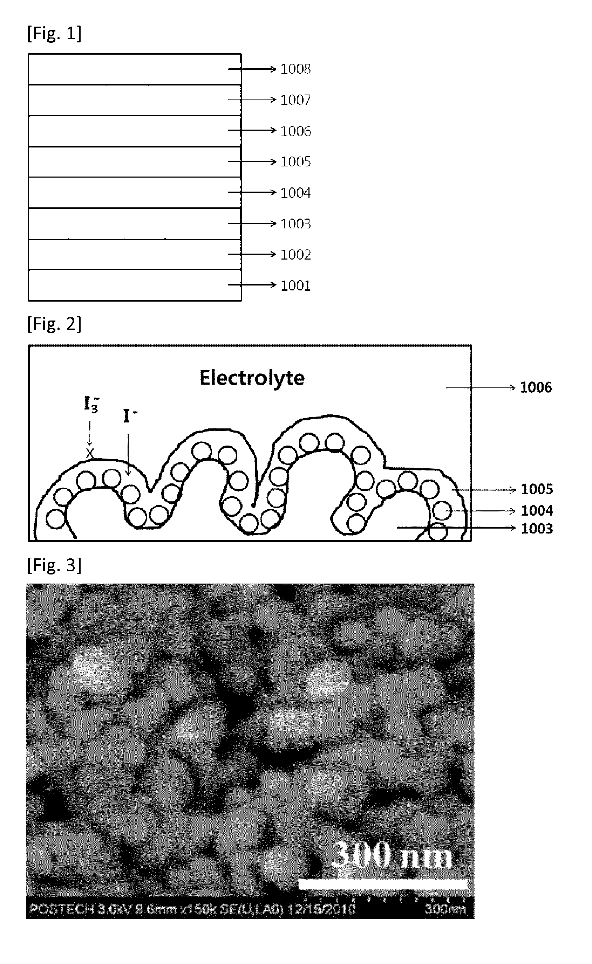

FIG. 1 is a cross-sectional view illustrating the dye-sensitized solar cell manufactured using a metal oxide semiconductor electrode having a porous polymer thin film and adsorbed dye molecules, according to a preferred embodiment of the present invention. As illustrated in the drawing, the dye-sensitized solar cell manufactured according to the embodiment of the present invention is provided in the form of a multilayer thin film configured such that a first electrode 1002 and a second electrode 1007 are disposed to face each other between two transparent substrates, that is, a first substrate 1001 and a second substrate 1008, and an inorganic oxide layer 1003, a dye/reactive material layer 1004, a porous polymer thin film layer 1005 and an electrode layer 1006 are disposed between the first electrode 1002 and the second electrode 1007.

The first substrate 1001 may be made of a transparent material such as glass or plastic, including, for example, PET (polyethylene terephthalate), PEN (polyethylene naphthalate), PP (polypropylene), PI (polyamide), TAC (tri acetyl cellulose), etc., and is preferably made of glass.

The first electrode 1002 is an electrode formed on one surface of the first substrate 1001 using a transparent material. The first electrode 1002 functions as an anode, and the first electrode 1002 may be formed of any material having transparency and conductivity as a material having a work function lower than the second electrode 1007. In the present invention, the first electrode 1002 may be provided in the form of a coating film or applied on the surface of the first substrate 1001 using sputtering or spin coating.

In regard to the present invention, the material for the first electrode 1002 may be arbitrarily selected from among ITO (indium-tin oxide), FTO (Fluorine doped tin oxide), ZnO-(Ga₂O₃ or Al₂O₃), SnO₂-Sb₂O₃, etc. Preferably useful is ITO or FTO.

The inorganic oxide layer 1003 is preferably made of a transition metal oxide in a nanoparticle form, for example, a transition metal oxide, such as titanium oxide, scandium oxide, vanadium oxide, zinc oxide, gallium oxide, yttrium oxide, zirconium oxide, niobium oxide, molybdenum oxide, indium oxide, tin oxide, lanthanide oxide, tungsten oxide, or iridium oxide, an alkaline earth metal oxide such as magnesium oxide or strontium oxide, aluminum oxide, etc. In regard to the present invention, a material particularly useful as the inorganic oxide is titanium oxide in a nanoparticle form.

According to the present invention, the inorganic oxide layer 1003 is applied on the first electrode 1002 by coating one surface of the first electrode 1002 therewith and then performing heat treatment. Typically, a paste including an inorganic oxide may be applied to a thickness of about 5 ∼ 30 µm, preferably 10 ∼ 15 µm on the surface of the first electrode 1002 using a doctor blade process or a screen printing process, or a spin coating process, a spraying process, a wet coating process, etc., may be carried out.

Functional layers having various functions are provided on the inorganic oxide layer 1003 of the dye-sensitized solar cell according to the present invention. A porous polymer thin film layer 1005 which is connected with the reactive material is formed on the inorganic oxide layer 1003 in order to minimize transfer of electrons between the dye molecules and to delay recombination of photoelectrons and oxidized chemical species in the electrolyte or holes of the hole transport material.

On the other hand, the dye transfers electrons to the inorganic oxide and then is oxidized, but receives electrons transported to the electrolyte layer 1006 and thus is reduced to an original state. Accordingly, the electrolyte layer 1006 receives electrons from the second electrode 1007 to transport them to the dye.

According to the present invention, a photosensitive dye chemically adsorbed on the inorganic oxide layer 1003 may include a dye such as a ruthenium complex as a material able to absorb light in the UV light and visible light ranges. For example, the photosensitive dye may include a ruthenium complex, such as Ruthenium 535 dye, Ruthenium 535 bis-TBA dye, Ruthenium 620-1H3TBA dye, etc. Preferably useful is a Ruthenium 535 bis-TBA dye. The photosensitive dye which may be chemically adsorbed on the inorganic oxide layer 1003 may include any dye having a charge separation function, such as a xanthene-based dye, a cyanine-based dye, a porphyrin-based dye, an anthraquinone-based dye, and an organic dye, in addition to the ruthenium-based dye.

The dye may be adsorbed on the inorganic oxide layer 1003 using a typical process. Preferably, the dye may be adsorbed by dissolving the dye in a solvent such as alcohol, nitrile, halogenated hydrocarbon, ether, amide, ester, ketone, N-methylpyrrolidone, etc., or preferably dissolving the dye in a co-solvent of acetonitrile and t-butanol, and then immersing the photoelectrode coated with the inorganic oxide layer 1003 in the dye solution.

The electrolyte used in the electrolyte layer 1006 may include a combination of I₂ and a metal iodide or an organic iodide (metal iodide or organic iodide/I₂) or a combination of Br₂ and a metal bromide or an organic bromide (metal bromide or organic bromide/Br₂) as a redox couple.

In the electrolyte used in the present invention, the metal cation of the metal iodide or the metal bromide may include Li, Na, K, Mg, Ca, Cs, etc., and the cation of the organic iodide or the organic bromide may include an ammonium compound such as imidazolium, tetra-alkyl ammonium, pyridinium, triazolium, etc., but the present invention is not limited thereto, and these compounds may be used in mixtures of two or more. Preferably useful as the redox couple is a combination of Lil or imidazolium iodide and I₂. Examples of the organic halide useful as the ionic liquid in the electrolyte according to the present invention may include n-methylimidazolium iodide, n-ethylimidazolium iodide, 1-benzyl-2-methylimidazolium iodide, 1-ethyl-3-methylimidazolium iodide, 1-butyl-3-methylimidazolium iodide, etc. Preferably useful is 1-ethyl-3-methylimidazolium iodide, and these may be used in a combination with iodine (I₂). In the case where such an ionic liquid, that is, a dissolved salt, is used, a solid electrolyte in which no solvent is used in the electrolyte composition may be provided.

The second electrode 1007 is an electrode applied on the surface of the second substrate 1008, and functions as a cathode. The second electrode 1007 may be applied on the surface of the second substrate 1008 by sputtering or spin coating. The material for the second electrode 1007 has a work function higher than the material for the first electrode 1002, and examples thereof may include platinum (Pt), gold (Au), silver (Ag), carbon (C), etc. Preferably useful is platinum. The second substrate 1008 may be made of a transparent material as in the case of the first substrate 1001, including glass, or plastic, such as PET, PEN, PP, PI, TAC, etc., and is preferably made of glass. The process of manufacturing the dye-sensitized solar cell according to a preferred embodiment of the present invention is described below.

Specifically, an inorganic oxide such as titanium oxide in a colloidal state is preferably applied or cast to a thickness of about 5 ∼ 30 µm on a first substrate coated with a first electrode material, and sintered at about 450 ∼ 550°C, thus forming a photoelectrode comprising the organic material-free first substrate, the first electrode and the inorganic oxide which are sequentially applied/layered. Subsequently, in order to adsorb a dye on the inorganic oxide layer, a dye, for example, a ruthenium-based N719 dye and a reactive co-adsorbent represented by general formulas (1) to (6) are added to a previously prepared ethanol solution, thus preparing a dye solution, after which a transparent substrate (e.g. a glass substrate coated with FTO, etc., a photoelectrode) coated with the inorganic oxide layer is immersed in the dye solution, so that the dye and the reactive co-adsorbent are adsorbed.

On the transparent substrate adsorbed with the dye and the reactive co-adsorbent, a mixture solution comprising a monomer connected by R₂ among compounds represented by general formulas (7) to (12) and a cross-linking agent at a molar ratio of 0.05 ∼ 50 or further comprising a dissolved initiator is applied and polymerized using heat or light. A platinum precursor material on the glass substrate is sintered, thus manufacturing a platinum electrode, which is then bound to a semiconductor electrode coated with a porous polymer thin film, followed by injecting an electrolyte, thereby manufacturing a dye-sensitized solar cell according to the present invention.

### Advantageous Effects

According to the present invention, a dye-sensitized solar cell is made of a material able to regenerate a dye by transporting holes to a counter electrode from the oxidized dye interposed between the counter electrode and a metal oxide semiconductor electrode coated with a porous polymer thin film which may prevent approach of a triiodide and may strongly fix dye molecules to the surface of a metal oxide while the dye molecules and a reactive compound are uniformly dispersed in a porous film including metal oxide semiconductor particles.

Also, the porous polymer thin film according to the present invention can be formed to surround the surface of the metal oxide adsorbed with the dye, thus minimizing the desorption of the dye molecules and the recombination, which are regarded as the most serious causes of lowered durability of the cell, so that open-circuit voltage and short-circuit current can be simultaneously improved, significantly increasing photoelectric conversion efficiency and drastically improving durability of the cell. Therefore, the present invention provides a technique for developing a dye-sensitized solar cell having high efficiency, low cost and long-term stability.

### Description of Drawings

FIG. 1 is a cross-sectional view illustrating the configuration of a dye-sensitized solar cell according to the present invention;
FIG. 2 is a cross-sectional view illustrating a titanium oxide electrode having a porous polymer thin film according to the present invention;
FIG. 3 is an image illustrating the cross-section of the titanium oxide layer at 150,000 magnification;
FIG. 4 is an image illustrating the cross-section of the titanium oxide layer having the porous polymer thin film according to the present invention at 150,000 magnification;
FIG. 5 is a graph illustrating a durability test for thermal (80°C) stability of the cells of Example 1 and Comparative Example 1;

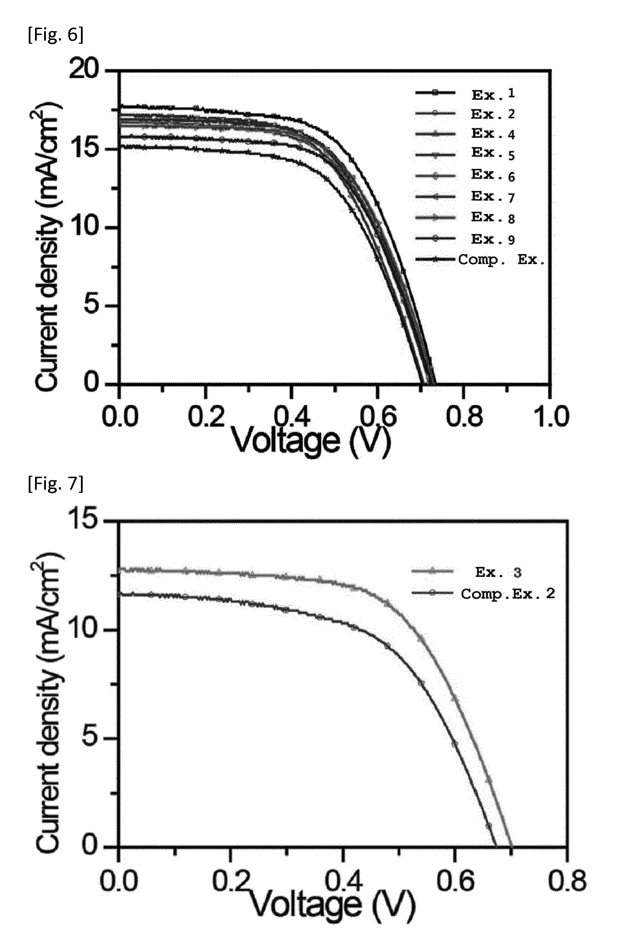

FIG. 6 is a graph illustrating voltage-current properties of Examples 1, 2, 4 ∼ 8 and Comparative Example 1; and
FIG. 7 is a graph illustrating voltage-current properties of Example 3 and Comparative Example 2.

### Mode for Invention

### Example 1

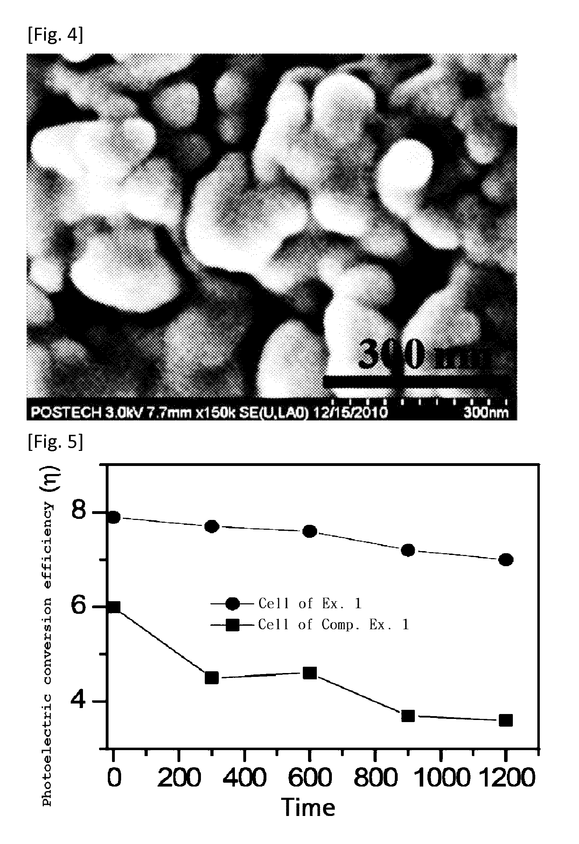

A composition for forming a TiO₂ (solaronix) porous film was applied using a doctor blade process on a transparent glass substrate having a substrate resistance of 15 Ω/□ and coated with fluorine-doped ITO. Drying and then heat treatment at 500°C for 30 min were carried out, thus forming a porous film having TiO₂. The thickness of the formed porous film was about 6 µm. Subsequently, a first electrode having the porous film was immersed for 18 hr in a solution comprising acetonitrile and tert-butanol (1:1 volume ratio) solvents and 0.30 mM ruthenium(4,4-dicarboxy-2,2'-bipyridine)₂(NCS) as a dye and 0.30 mM methacryloyl-4-aminobutyric acid as a co-adsorbent, so that the dye was adsorbed on the porous film. Subsequently, a solution comprising methylmethacrylate and 1,6-hexanediol diacrylate at a molar ratio of 2 was applied on the first electrode having the porous film adsorbed with the dye and the co-adsorbent, and was then cross-linked at 80°C for 30 min. FIGS. 4 and 5 are images illustrating the cross-section of the porous polymer thin film formed while surrounding the TiO₂ particles as observed by SEM at 6,000 and 150,000 magnifications.

A platinum paste (solaronix) was applied using a doctor blade process on a transparent glass substrate having a substrate resistance of 15 Ω/□ and coated with fluorine-doped ITO. Drying and then heat treatment at 450°C for 30 min were carried out, thus manufacturing a catalyst electrode to form a second electrode. A bore was formed in the second electrode using a 0.75 mm drill.

0.6M 1-butyl-3-methylimidazolium iodide, 0.03M iodine, 0.10M guanidinium thiocyanate, and 0.5M 4-tert-butylpyridine were dissolved in acetonitrile and valeronitrile (85:15 volume ratio) solvents, thus preparing an electrolyte, which was then injected via the bore, after which the bore was sealed with an adhesive, thereby manufacturing a dye-sensitized solar cell.

### Example 2

A dye-sensitized solar cell was manufactured in the same manner as in Example 1, with the exception that the electrolyte was prepared by dissolving 0.8M 1-butyl-3-methylimidazolium iodide, 0.03M iodine, and 0.2M 4-tert-butylpyridine in a methoxypropionitrile solvent.

### Example 3

A dye-sensitized solar cell was manufactured in the same manner as in Example 2, with the exception that the electrolyte was prepared by mixing the electrolyte of Example 2 with a solution comprising methylmethacrylate and 1,6-hexanediol diacrylate at a ratio of 4, and was then cross-linked again, thereby manufacturing a semi-solid dye-sensitized solar cell.

### Example 4

A dye-sensitized solar cell was manufactured in the same manner as in Example 1, with the exception that the solution comprising methylmethacrylate and 1,6-hexanediol diacrylate at a molar ratio of 4 was used.

### Example 5

A dye-sensitized solar cell was manufactured in the same manner as in Example 1, with the exception that the solution comprising methylmethacrylate and 1,6-hexanediol diacrylate at a molar ratio of 0.5 was used.

### Example 6

A dye-sensitized solar cell was manufactured in the same manner as in Example 1, with the exception that styrene was used, instead of methylmethacrylate.

### Example 7

A dye-sensitized solar cell was manufactured in the same manner as in Example 1, with the exception that 1,4-butanediol diacrylate was used instead of 1,6-hexanediol diacrylate.

### Example 8

A dye-sensitized solar cell was manufactured in the same manner as in Example 1, with the exception that methacryloyl-4-aminolauric acid was used as the co-adsorbent, instead of methacryloyl-4-aminobutyric acid.

### Comparative Example 1

A composition for forming a TiO₂ (solaronix) porous film was applied using a doctor blade process on a transparent glass substrate having a substrate resistance of 15Ω/□ and coated with fluorine-doped ITO. Drying and then heat treatment at 500°C for 30 min were carried out, thus forming a porous film having TiO₂. The thickness of the formed porous film was about 6 µm.

Subsequently, a first electrode having the porous film was immersed for 18 hr in a solution comprising acetonitrile and tert-butanol (1:1 volume ratio) solvents and 0.30 mM ruthenium(4,4-dicarboxy-2,2'-bipyridine)₂(NCS) as a dye, so that the dye was adsorbed on the porous film.

A platinum paste (solaronix) was applied using a doctor blade process on a transparent glass substrate having a substrate resistance of 15 Ω/□ and coated with fluorine-doped ITO. Drying and then heat treatment at 450°C for 30 min were performed, thus manufacturing a catalyst electrode to form a second electrode. A bore was formed in the second electrode using a 0.75 mm drill.

0.6M 1-butyl-3-methylimidazolium iodide, 0.03M iodine, 0.10M guanidinium thiocyanate, and 0.5M 4-tert-butylpyridine were dissolved in acetonitrile and valeronitrile (85:15 volume ratio) solvents, thus preparing an electrolyte, which was then injected via the bore, after which the bore was sealed with an adhesive, thereby manufacturing a dye-sensitized solar cell.

### Comparative Example 2

A dye-sensitized solar cell was manufactured in the same manner as in Comparative Example 1, with the exception that the electrolyte was prepared by dissolving 0.8M 1-butyl-3-methylimidazolium iodide, 0.03M iodine, and 0.2M 4-tert-butylpyridine in a methoxypropionitrile solvent, thus preparing a solution and then mixing this solution with a solution of methylmethacrylate and 1,6-hexanediol diacrylate at a ratio of 4, and was then cross-linked again, thus manufacturing a semi-solid dye-sensitized solar cell.

### Example 9

The dye-sensitized solar cell of Example 1 was stored at 80°C, and taken out at 200 hr, 400 hr, 600 hr, 800 hr, 1000 hr, and 1200 hr, and the solar cell efficiency thereof was measured.

### Comparative Example 3

The dye-sensitized solar cell of Comparative Example 1 was stored at 80°C, and taken out at 200 hr, 400 hr, 600 hr, 800 hr, 1000 hr, and 1200 hr, and the solar cell efficiency thereof was measured.

| | Open-circuit voltage (V) | Short-circuit current (mA/cm²) | Filling factor (%) | Efficiency (%) |
|---|---|---|---|---|
| Ex. 1 | 0.732 | 17.8 | 60.4 | 7.9 |
| Ex. 2 | 0.720 | 16.9 | 59.1 | 7.2 |
| Ex. 3 | 0.702 | 12.7 | 60.1 | 5.4 |
| Ex. 4 | 0.723 | 17.2 | 58.5 | 7.3 |
| Ex. 5 | 0.726 | 16.7 | 57.8 | 7.0 |
| Ex. 6 | 0.708 | 16.9 | 58.1 | 6.9 |
| Ex. 7 | 0.732 | 16.5 | 60.0 | 7.2 |
| Ex. 8 | 0.726 | 15.8 | 60.0 | 6.9 |
| Comp. Ex. 1 | 0.701 | 15.1 | 59.1 | 6.3 |
| Comp. Ex. 2 | 0.675 | 11.6 | 56.7 | 4.5 |

The porous polymer thin film according to the present invention is formed to surround the surface of the metal oxide adsorbed with the dye, thus minimizing desorption of dye molecules and recombination, which are regarded as the most serious causes of decreased durability of the cell, thereby improving both open-circuit voltage and short-circuit current, thus significantly increasing photoelectric conversion efficiency and drastically improving durability of the cell. Therefore the present invention provides a technique for developing a dye-sensitized solar cell having high efficiency, low cost and long-term stability. Specifically, the technique for developing the dye-sensitized solar cell able to simultaneously achieve high efficiency, low cost, and long-term stability is provided, thus exhibiting very high industrial applicability.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A dye-sensitized solar cell, comprising a semiconductor electrode, a counter electrode and an electrolyte, wherein the semiconductor electrode is configured such that a polymer thin film is formed on a porous thin layer including a metal oxide semiconductor and being adsorbed with dyes.

2. The solar cell of claim 1, wherein the polymer thin film is fixed to a metal oxide.

3. The solar cell of claim 1 or 2, wherein the polymer thin film is formed by adsorbing a dye molecule and a reactive adsorbent on the metal oxide and copolymerizing a monomer and a cross-linking agent.

4. The solar cell of claim 1 or 2, wherein the polymer thin film is a porous thin film.

5. The solar cell of claim 1 or 2, wherein the polymer thin film is a cross-linked polymer thin film.

6. The solar cell of claim 1 or 2, wherein the metal oxide is one or more selected from among titanium oxide, scandium oxide, vanadium oxide, zinc oxide, gallium oxide, yttrium oxide, zirconium oxide, niobium oxide, molybdenum oxide, indium oxide, tin oxide, lanthanide oxide, tungsten oxide, iridium oxide, magnesium oxide, strontium oxide, an alkaline earth metal oxide, and aluminum oxide.

7. The solar cell of claim 1 or 2, wherein the dye is one or more selected from among a ruthenium-based dye, a xanthene-based dye, a cyanine-based dye, a porphyrin-based dye, and an anthraquinone-based dye.

8. The solar cell of claim 3, wherein the reactive adsorbent is a reactive co-adsorbent which is co-adsorbed along with the dye.

9. The solar cell of claim 8, wherein the reactive co-adsorbent is one or more selected from among the following formulas (1) to (6): 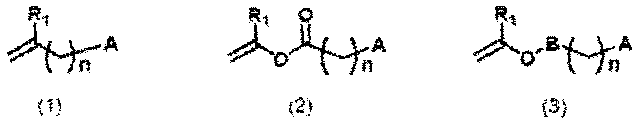 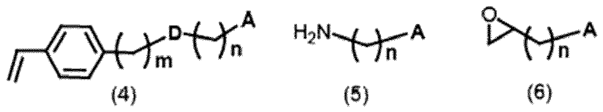 wherein R₁ is hydrogen, or a C1 ∼ C10 alkyl group, A contains one or more selected from among a carboxyl group, acyl halide, alkoxy silyl, halide silyl and phosphorus, B is selected from among a carbon atom, a nitrogen atom, an oxygen atom, a silicon atom, and a phosphorus atom, n is a natural number of 1 ∼ 40, m is 0 or a natural number of 1 ∼ 10, and D is a connector comprising one or more selected from among a carbon atom, a nitrogen atom, an oxygen atom, a silicon atom, and a phosphorus atom.

10. The solar cell of claim 9, wherein the reactive co-adsorbent is one or more selected from the group consisting of but-3-enoic acid, pent-4-enoic acid, hex-4-enoic acid, hep-4-enoic acid, non-9-enoic acid, malonic acid monovinylester, succinic acid monovinylester, heptanedioic acid monovinylester, 4-oxo-hex-5-enoic acid, acrylic acid carboxymethyl ester, methacryloyl-4-aminobutyric acid, 6-acryloylamino-hexanoic acid, 9-acryloylamino-nonanoic acid, 6-(2-methyl-acryloylamino)-hexanoic acid, 9-(2-methyl-acryloylamino)-nonanoic acid, 14-acryloyloxy-tetradecanoic acid, 14-(2-methyl-acryloyloxy-tetradecanoic acid), 4-(4-vinyl-phenyl)butyric acid, 4-(4-vinyl-phenoxy)-propionic acid, 6-(4-vinyl-phenyl)hexylic acid, 6-(4-vinyl-phenoxy)-hexanoic acid, 6-amino-hexanoic acid, 8-amino-octanoic acid, 6-oxyrenyl-hexanoic acid, and 8-oxyrenyl-octanoic acid.

11. The solar cell of claim 9 or 10, wherein the polymer thin film is an acrylic polymer thin film.

12. The solar cell of claim 1 or 2, wherein the electrolyte includes I₂ and a metal iodide, an organic iodide, or a mixture thereof as a redox couple, or includes Br₂ and a metal bromide, an organic bromide, or a mixture thereof as a redox couple.

13. A metal oxide semiconductor electrode, which is configured such that a polymer thin film is formed on a porous thin film including metal oxide semiconductor particles and adsorbed with a dye.

14. The metal oxide semiconductor electrode of claim 13, wherein the polymer thin film is a porous cross-linked thin film.

15. The metal oxide semiconductor electrode of claim 13 or 14, wherein the polymer thin film is fixed to a surface of a metal oxide.

16. The metal oxide semiconductor electrode of claim 13, wherein the polymer thin film is formed by applying a monomer and a cross-linking agent on the metal oxide and then copolymerizing the monomer and the cross-linking agent.

17. The metal oxide semiconductor electrode of claim 16, wherein the polymer thin film is formed by being adsorbed with a dye molecule and a reactive compound.

18. The metal oxide semiconductor electrode of claim 17, wherein the polymer thin film is an acrylic polymer thin film.

19. A method of manufacturing a dye-sensitized solar cell, comprising forming a porous thin film on a porous film including metal oxide semiconductor particles.

20. The method of claim 18, wherein the porous film has higher electron permeability compared to an oxidation species of a redox couple contained in an electrolyte.

21. The method of claim 18 or 19, wherein the porous thin film is a polymer thin film obtained by applying a monomer on a porous film and cross-linking and polymerizing the monomer.

22. A dye-sensitized solar cell, wherein a porous thin film having pores smaller than a triiodide ion is formed on a surface of a semiconductor electrode.
